# EUROPÄISCHE PATENTSCHRIFT

(11) **EP 2 406 828 B1**
(45) Veröffentlichungstag und Bekanntmachung des Hinweises auf die Patenterteilung: **10.07.2019**
(21) Anmeldenummer: 10707060.9
(22) Anmeldetag: 10.03.2010
(51) Int. Cl.: H01L 31/0216, H01L 31/0203, H01L 31/0352

(54) **STRAHLUNGSEMPFANGENDES HALBLEITERBAUELEMENT UND OPTOELEKTRONISCHES BAUTEIL**
RADIATION-RECEIVING SEMICONDUCTOR COMPONENT AND OPTOELECTRONIC DEVICE
COMPOSANT SEMI-CONDUCTEUR RÉCEPTEUR DE RAYONNEMENT ET COMPOSANT ÉLECTRO-OPTIQUE

(30) Priorität: 12.03.2009 DE 102009012755
(43) Veröffentlichungstag der Anmeldung: 18.01.2012
(73) Patentinhaber: OSRAM Opto Semiconductors GmbH, 93055 Regensburg (DE)
(72) Erfinder: MÜLLER, Christian, 93180 Deuerling (DE); KUHLMANN, Werner, 81541 München (DE)
(74) Vertreter: Zacco Patent- & Rechtsanwälte
(86) Internationale Anmeldenummer: PCT/EP2010/053046
(87) Internationale Veröffentlichungsnummer: WO 2010/103047

(56) Entgegenhaltungen:
- EP-A1- 1 589 586
- DE-A1- 10 101 457
- GB-A- 1 590 865
- JP-A- 56 165 369
- JP-A- 61 113 287
- JP-A- 2006 301 489
- US-A- 4 158 133
- US-A1- 2003 218 175
- US-A1- 2005 041 292
- US-A1- 2007 108 545

## Beschreibung

Es wird ein strahlungsempfangendes Halbleiterbauelement angegeben. Darüber hinaus wird ein optoelektronisches Bauteil mit einem solchen strahlungsempfangenden Halbleiterbauelement Die Dokumente US2005041292, EP1589586 und US2007108545 offenbaren strahlungsempfangenden Halbleiterbauelemente vom Stand der Technik.

Eine zu lösende Aufgabe besteht darin, ein strahlungsempfangendes Halbleiterbauelement anzugeben, dessen spektrale Empfindlichkeit besonders gut an die spektrale Empfindlichkeit des menschlichen Auges angepasst ist. Eine weitere zu lösende Aufgabe besteht darin, ein optoelektronisches Bauteil mit solch einem strahlungsempfangenden Halbleiterbauelement anzugeben.

Die Aufgabe der Erfindung wird durch den Gegenstand des Anspruchs 1 gelöst.

Erfindungsgemäß umfasst dieses einen Halbleiterkörper, der mit Silizium gebildet ist. Das heißt, der Halbleiterkörper des strahlungsempfangenden Halbleiterbauelements basiert auf Silizium. Er umfasst beispielsweise zumindest einen p-n-Übergang, der mit einem p-dotierten Bereich des mit Silizium gebildeten Halbleiterkörpers und einem n-dotierten Bereich des mit Silizium gebildeten Halbleiterkörpers gebildet ist. Der Halbleiterkörper kann dabei - abgesehen von den Dotierstoffen - aus Silizium bestehen.

Insbesondere der Bereich des Halbleiterkörpers, in dem elektromagnetische Strahlung absorbiert und zu elektrischem Strom umgewandelt wird, besteht dann - abgesehen von den Dotierstoffen - aus Silizium.

Außerdem umfasst der Halbleiterkörper des strahlungsempfangenden Halbleiterbauelements eine Strahlungseintrittsfläche. Die Strahlungseintrittsfläche des Halbleiterkörpers ist beispielsweise durch eine Hauptfläche, zum Beispiel an einer Oberseite des Halbleiterkörpers, gebildet. Durch die Strahlungseintrittsfläche tritt zu detektierende elektromagnetische Strahlung in den Halbleiterkörper ein.

Außerdem weist der Halbleiterkörper eine Absorptionszone auf, in der durch die Strahlungseintrittsfläche in den Halbleiterkörper tretende elektromagnetische Strahlung absorbiert wird. Lediglich in der Absorptionszone absorbierte elektromagnetische Strahlung trägt dabei zur Erzeugung von elektrischem Strom und damit zur Erzeugung eines Signals des strahlungsempfangenden Halbleiterbauelements bei.

In anderen Bereichen als der Absorptionszone absorbierte elektromagnetische Strahlung trägt nicht zum Signal des strahlungsempfangenden Halbleiterbauelements bei. Die elektromagnetische Strahlung wird beispielsweise in Bereichen des Halbleiterkörpers, die außerhalb der Absorptionszone liegen, absorbiert. Die Absorptionszone kann dabei unmittelbar an die Strahlungseintrittsfläche des Halbleiterkörpers grenzen. Das heißt, befindet sich die Strahlungseintrittsfläche beispielsweise in einer Hauptfläche des Halbleiterkörpers, die an einer Oberseite des Halbleiterkörpers liegt, so kann sich die Absorptionszone von der Strahlungseintrittsfläche bis zu einer bestimmten Tiefe in den Halbleiterkörper hinein erstrecken. Das heißt, die Absorptionszone erstreckt sich dann von der Strahlungseintrittsfläche an der Oberseite des Halbleiterkörpers bis zu einer gewissen Tiefe in Richtung der der Oberseite abgewandten Unterseite des Halbleiterkörpers.

Erfindungsgemäß weist die Absorptionszone eine Dicke von höchstens 10 µm auf. Vorzugsweise weist die Absorptionszone eine Dicke zwischen 1,5 und 7,5 µm, besonders bevorzugt zwischen wenigstens 2 µm und höchstens 5 µm auf. Durch eine solch dünne Absorptionszone ist beispielsweise sichergestellt, dass die maximale Empfindlichkeit des strahlungsempfangenden Halbleiterbauelements von relativ langen Wellenlängen im Bereich zwischen 800 und 900 nm in einen Bereich kürzerer Wellenlängen zwischen beispielsweise 500 und 600 nm verschoben ist. Das heißt, in der dünnen Absorptionszone wird Strahlung kürzerer Wellenlänge mit höherer Wahrscheinlichkeit absorbiert als Strahlung längerer Wellenlänge. Die nicht absorbierte elektromagnetische Strahlung kann die Absorptionszone durchdringen und beispielsweise in einem Bereich des Halbleiterkörpers absorbiert werden, in dem sie nicht zur Signalbildung des strahlungsempfangenden Halbleiterbauelements beitragen kann.

Die Dicke der Absorptionszone wird dabei in einer Richtung gemessen, die auf der Strahlungseintrittsfläche des strahlungsempfangenden Halbleiterbauelements senkrecht steht. Beispielsweise kann es sich bei dieser Richtung auch um die Wachstumsrichtung des epitaktisch abgeschiedenen Teils des Halbleiterkörpers handeln.

Bei der Filterschicht handelt es sich um einen Interferenzfilter, der als Kantenfilter ausgebildet ist. Die Filterschicht überdeckt die Strahlungseintrittsfläche des Halbleiterkörpers vorzugsweise vollständig, sodass sämtliche elektromagnetische Strahlung, die durch die Strahlungseintrittsfläche des Halbleiterkörpers in diesen eindringt, vorher die Filterschicht durchlaufen hat und von dieser gefiltert wurde.

Die Filterschicht ist geeignet, elektromagnetische Strahlung im Wellenlängenbereich von Infrarotstrahlung, insbesondere aus dem nahen Infrarot von Wellenlängen zwischen 800 nm und 1100 nm, zu filtern, das heißt am Eindringen in den Halbleiterkörper zu hindern oder in ihrer Intensität zumindest abzuschwächen.

Erfindungsgemäß umfasst das strahlungsempfangende Halbleiterbauelement einen Vergusskörper, der den Halbleiterkörper zumindest an seiner Strahlungseintrittsfläche überdeckt. Der Vergusskörper ist beispielsweise mit einem Silikon oder einem Epoxydharz gebildet und derart auf dem Halbleiterkörper angeordnet, dass er die Strahlungseintrittsfläche des Halbleiterkörpers vollständig überdeckt. Das heißt, sämtliche elektromagnetische Strahlung, welche durch die Strahlungseintrittsfläche in den Halbleiterkörper eindringt, hat vor dem Eindringen in den Halbleiterkörper den Vergusskörper durchlaufen. Der Vergusskörper enthält dabei ein strahlungsabsorbierendes Material. Das heißt, die elektromagnetische Strahlung tritt vor dem Eintritt in den Halbleiterkörper durch den Vergusskörper, in dem das strahlungsabsorbierende Material enthalten ist, das einen Teil dieser Strahlung, vorzugsweise wellenlängenselektiv, absorbiert.

Erfindungsgemäß umfasst das Halbleiterbauelement einen Halbleiterkörper, der mit Silizium gebildet ist und eine Strahlungseintrittsfläche sowie eine Absorptionszone aufweist, in der durch die Strahlungseintrittsfläche in den Halbleiterkörper tretende elektromagnetische Strahlung absorbiert wird. Die Dicke der Absorptionszone beträgt dabei höchstens 10 µm. Das strahlungsempfangende Halbleiterbauelement umfasst ferner eine Filterschicht, die mit einem dielektrischen Material gebildet ist, wobei die Filterschicht die Strahlungseintrittsfläche des Halbleiterkörpers bedeckt, und das Halbleiterbauelement umfasst einen Vergusskörper, der den Halbleiterkörper zumindest an seiner Strahlungseintrittsfläche überdeckt, wobei der Vergusskörper ein strahlungsabsorbierendes Material enthält.

Das hier beschriebene strahlungsempfangende Halbleiterbauelement beruht dabei unter anderem auf der Erkenntnis, dass sich auf Grundlage eines Halbleiterkörpers, der mit Silizium gebildet ist, ein optischer Detektor, zum Beispiel eine Fotodiode oder ein Fototransistor, besonders kostengünstig herstellen lässt. Ferner beruht das Halbleiterbauelement auf der Erkenntnis, dass die Kombination unterschiedlicher Maßnahmen - wie eine bestimmte Dicke der Absorptionszone, eine Filterschicht und ein Vergusskörper, der ein strahlungsabsorbierendes Material enthält - geeignet sein können, die spektrale Empfindlichkeit des strahlungsempfangenden Halbleiterbauelements an die spektrale Empfindlichkeit des menschlichen Auges möglichst genau anzupassen.

Erfindungsgemäß ist die Filterschicht zur Filterung von Infrarotstrahlung vorgesehen. Das heißt, die Filterschicht ist geeignet, einen Anteil der elektromagnetischen Strahlung, die auf das Halbleiterbauelement trifft, vor dem Eindringen in den Halbleiterkörper wenigstens zu schwächen. Die gefilterte elektromagnetische Strahlung weist dabei beispielsweise eine Wellenlänge von 800 nm oder höher auf.

Gemäß zumindest einer Ausführungsform des strahlungsempfangenden Halbleiterbauelements umfasst die Filterschicht zumindest eine Schicht, die aus einem der folgenden Materialien gebildet ist: Siliziumoxid, Siliziumnitrit. Dabei ist es auch möglich, dass die Filterschicht mehrere Schichten umfasst, die übereinander - zum Beispiel parallel zur Strahlungseintrittsfläche des Halbleiterkörpers - angeordnet sind. Die Schichten können sich dabei hinsichtlich ihres Brechungsindex voneinander unterscheiden und einen Interferenzkantenfilter ausbilden. Beispielsweise sind Schichten aus Siliziumoxid und Siliziumnitrit übereinander angeordnet. Bei dem Siliziumoxid handelt es sich vorzugsweise um Siliziumdioxid, bei dem Siliziumnitrit handelt es sich um Si3N4.

Erfindungsgemäß befindet sich die Filterschicht in direktem Kontakt mit der Strahlungseintrittsfläche des Halbleiterkörpers. Das heißt, die Filterschicht ist unmittelbar auf der Strahlungseintrittsfläche des Halbleiterkörpers angeordnet. Die Filterschicht kann beispielsweise auf die Strahlungseintrittsfläche aufgedampft oder aufgesputtert sein. Die Filterschicht kann dazu zum Beispiel wenigstens vier Schichten umfassen, wobei sich zumindest zwei der Schichten in ihrem Brechungsindex voneinander unterscheiden. Die Filterschicht trägt dazu bei, die Rest-Infrarotempfindlichkeit des Halbleiterkörpers, der mit Silizium gebildet ist, zu unterdrücken.

Gemäß zumindest einer Ausführungsform des strahlungsempfangenden Halbleiterbauelements umfasst die Filterschicht höchstens zehn einzelne Schichten. Eine solche Filterschicht ist besonders kostengünstig herstellbar.

Gemäß zumindest einer Ausführungsform des strahlungsempfangenden Halbleiterbauelements ist der Vergusskörper mit zumindest einem der folgenden Materialien gebildet: Silikon, Epoxydharz. Darüber hinaus ist es auch möglich, dass der Vergusskörper mit einem Silikon-Epoxydharz-Hybridmaterial gebildet ist. In den Vergusskörper ist dann vorzugsweise ein strahlungsabsorbierendes Material, beispielsweise in Form von Partikeln, eingebracht. Das strahlungsabsorbierende Material kann dabei gleichmäßig im Vergusskörper verteilt sein oder innerhalb einer Schicht in diesem angeordnet sein. Das strahlungsabsorbierende Material befindet sich dann im Wesentlichen nur innerhalb dieser Schicht innerhalb des Vergusskörpers. Diese Schicht kann an ihren Hauptflächen vollständig vom Vergusskörper ohne absorbierendes Material bedeckt sein. Dies ermöglicht eine besonders genaue und definierte Absorption elektromagnetischer Strahlung durch das strahlungsabsorbierende Material.

Erfindungsgemäß ist das strahlungsabsorbierende Material zur Absorption von Infrarotstrahlung vorgesehen. Das heißt, das strahlungsabsorbierende Material ist zur Absorption von Infrarotstrahlung geeignet und absorbiert Infrarotstrahlung, bevor diese in den Halbleiterkörper eindringen kann. Zum Beispiel handelt es sich bei dem strahlungsabsorbierenden Material um das Additiv "IR-14" von der Firma Nitto.

Erfindungsgemäß ist die Filterschicht zwischen dem Halbleiterkörper und dem Vergusskörper angeordnet. Das heißt, die Filterschicht überdeckt die Strahlungseintrittsfläche des Halbleiterkörpers vollständig, und der Vergusskörper ist dann derart über dem Halbleiterkörper angeordnet, dass er die Filterschicht vollständig überdeckt. In das Halbleiterbauelement eintretende elektromagnetische Strahlung tritt also vor dem Eintreten in die Filterschicht vollständig durch den Vergusskörper mit dem strahlungsabsorbierenden Material und vor dem Eintreten in den Halbleiterkörper durch die Strahlungseintrittsfläche vollständig durch die Filterschicht. Die eintretende elektromagnetische Strahlung ist damit einem zweistufigen Absorptions- beziehungsweise Filterprozess unterworfen, in dem zum Beispiel längerwellige Anteile der elektromagnetischen Strahlung, mit einer Wellenlänge oberhalb von 800 nm, in ihrer Intensität zumindest abgeschwächt werden.

Erfindungsgemäß befindet sich der Vergusskörper zumindest stellenweise in direktem Kontakt mit der Filterschicht. Beispielsweise kann der Vergusskörper die Filterschicht vollständig überdecken und jede freie Fläche der Filterschicht, das heißt jede Fläche der Filterschicht, die nicht mit dem Halbleiterkörper in direktem Kontakt steht, benetzen.

Gemäß zumindest einer Ausführungsform des strahlungsempfangenden Halbleiterbauelements weist der Vergusskörper eine maximale Dicke von 600 µm auf. Beispielsweise weist der Vergusskörper eine Dicke von wenigstens 200 µm und höchstens 500 µm auf. Durch einen so dünnen Vergusskörper ist sichergestellt, dass möglichst wenig Material des Vergusskörpers zu seiner Herstellung notwendig ist.

Es wird darüber hinaus ein optoelektronisches Bauteil mit einem solchen strahlungsempfangenden Halbleiterbauelement angegeben. Das heißt, sämtliche Merkmale des strahlungsempfangenden Halbleiterbauelements sind auch für das optoelektronische Bauteil offenbart.

Gemäß zumindest einer Ausführungsform des optoelektronischen Bauteils umfasst das optoelektronische Bauteil einen Anschlussträger, der eine Oberseite aufweist. Bei dem Anschlussträger kann es sich zum Beispiel um eine Leiterplatte handeln.

Beispielsweise weist der Anschlussträger einen elektrisch isolierenden Grundkörper auf, in den oder auf den Leiterbahnen und Anschlussstellen strukturiert sind. Darüber hinaus kann es sich bei dem Anschlussträger um einen Trägerstreifen (auch leadframe) oder eine Metallkernplatine handeln.

Gemäß zumindest einer Ausführungsform des strahlungsempfangenden Bauteils ist das hier beschriebene strahlungsempfangende Halbleiterbauelement an der Oberseite des Anschlussträgers auf diesem befestigt. Das Halbleiterbauelement kann beispielsweise mit der der Strahlungseintrittsfläche des Halbleiterkörpers abgewandten Seite auf den Anschlussträger gelötet oder geklebt sein.

Gemäß zumindest einer Ausführungsform des optoelektronischen Bauteils befindet sich der Vergusskörper des strahlungsempfangenden Halbleiterbauteils in direktem Kontakt mit dem Anschlussträger und weist eine maximale Dicke von 600 µm auf. Das heißt, der Anschlussträger ist zumindest stellenweise vom Vergusskörper bedeckt. Dazu kann das Halbleiterbauelement zum Beispiel erst nach dem Aufbringen auf den Anschlussträger mit dem Vergusskörper versehen, etwa umspritzt werden.

Zum Beispiel befindet sich der Vergusskörper dabei ausschließlich an der Oberseite des Anschlussträgers mit dem Anschlussträger in Kontakt. Das heißt, es wird nicht der gesamte Anschlussträger mit dem Vergusskörper umspritzt, sondern lediglich ein Bereich mit einer maximalen Dicke von 600 µm um den Halbleiterkörper herum wird mit dem Vergusskörper umspritzt. Dadurch lässt sich das Material des Vergusskörpers gegenüber einem vollständigen Umspritzen des Anschlussträgers reduzieren. Auch das strahlungsabsorbierende Material im Vergusskörper lässt sich auf diese Weise besonders kontrolliert, zum Beispiel in eine Schicht, welche das Filterelement überdeckt, einbringen.

Im Folgenden werden das hier beschriebene strahlungsempfangende Halbleiterbauelement sowie das hier beschriebene optoelektronische Bauteil anhand von Ausführungsbeispielen und den dazugehörigen Figuren näher beschrieben.
- Die Figur 1: zeigt ein hier beschriebenes optoelektronisches Bauteil mit einem hier beschriebenen strahlungsempfangenden Halbleiterbauelement gemäß einem Ausführungsbeispiel in einer schematischen Schnittdarstellung.
- Die Figuren 2A bis 2C: zeigen anhand schematischer grafischer Auftragungen die Wirkungen von Komponenten des hier beschriebenen strahlungsempfangenden Halbleiterbauelements.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

Umgebungslichtsensoren (englisch: ambient light sensors) sollen die Umgebungshelligkeit in identischer Weise wie das menschliche Auge messen. Die spektrale Empfindlichkeit des menschlichen Auges wird durch die so genannte V-A-Kurve beschrieben, eine Empfindlichkeitskurve, die bei einer Wellenlänge λ ≈ 400 nm beginnt und ihr Maximum bei λ ≈ 550-560 nm hat und dann wieder bis λ = 780 nm auf 0 zurückgeht. Technische Fotodetektoren weisen zunächst eine davon abweichende Empfindlichkeitskurve auf, was zu entsprechenden Fehlmessungen im Vergleich zur Empfindlichkeitskurve des menschlichen Auges führt. Zur Anpassung an die Augenkurve der technischen Fotodetektoren sind oft teure Maßnahmen notwendig.

Es gibt dabei verschiedene Ansätze, Umgebungslichtsensoren herzustellen. Viele Halbleiterkörper, zum Beispiel Halbleiterkörper aus Silizium, weisen eine stark abweichende Empfindlichkeitskurve auf, die stark von der Empfindlichkeitskurve des menschlichen Auges abweicht. Andererseits zeichnen sich Umgebungslichtsensoren, die auf Silizium beruhen, dadurch aus, dass sie besonders kostengünstig herstellbar sind.

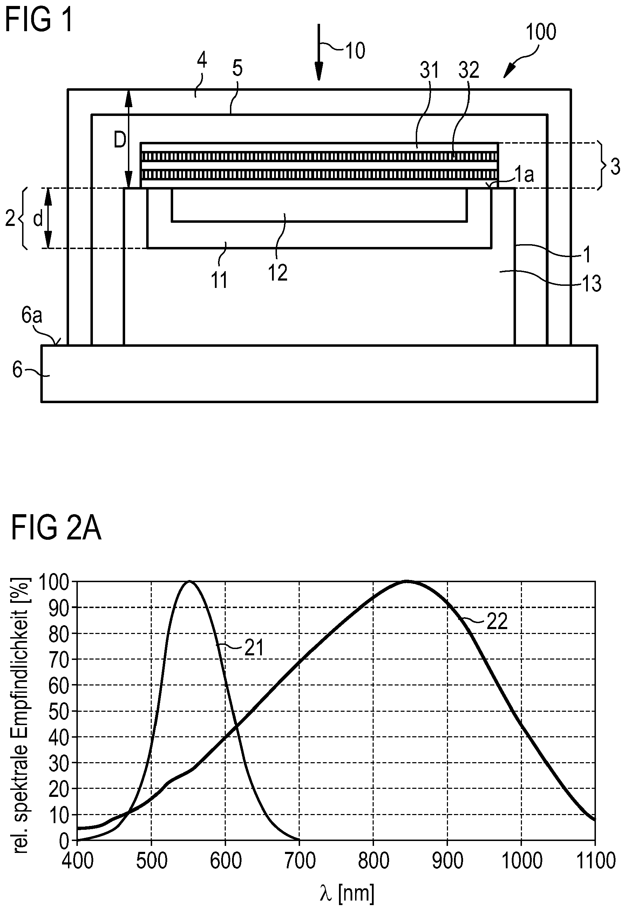

In Verbindung mit der Figur 1 ist anhand einer schematischen Schnittdarstellung ein hier beschriebenes optoelektronisches Bauteil mit einem hier beschriebenen strahlungsempfangenden Halbleiterbauelement 100 näher erläutert. Das Halbleiterbauelement 100 umfasst einen Halbleiterkörper 1.

Der Halbleiterkörper 1 weist eine Strahlungseintrittsfläche 1a auf, durch die in den Halbleiterkörper 1 tretende elektromagnetische Strahlung 10 treten muss, um in der Absorptionszone 2 des Halbleiterkörpers detektiert zu werden und ein Signal zu erzeugen. Vorliegend weist die Absorptionszone 2 eine Dicke d von maximal 10 µm, hier zum Beispiel 3 µm, auf. Vorliegend ist die dünne Absorptionszone durch eine p-n-p-Struktur realisiert. Der Halbleiterkörper 1 weist dazu einen ersten p-dotierten Bereich 12, einen n-dotierten Bereich 11 und einen zweiten p-dotierten Bereich 13 auf. Der der Strahlungseintrittsfläche 1a zugewandte p-n-Übergang zwischen dem ersten p-dotierten Bereich 12 und dem n-dotierten Bereich 11 dient zur Erzeugung des Fotostroms des Halbleiterbauelements 100. Der untere n-p-Übergang zwischen dem n-dotierten Bereich 11 und dem p-dotierten Bereich 13 ist kurzgeschlossen, sodass alle Ladungsträger, die unterhalb der Absorptionszone 2 durch einfallende elektromagnetische Strahlung 10 oder auf andere Weise erzeugt werden, rekombinieren, ohne zum Fotostrom beizutragen.

Alternativ kann eine dünne Absorptionszone mit einer Dicke von höchstens 10 µm auch auf andere Arten realisiert werden:
- Zum Beispiel kann eine dünne, beispielsweise zwischen 2 µm und 5 µm dicke, relativ schwach dotierte Epitaxieschicht Verwendung finden. Die Absorptionszone befindet sich dann innerhalb dieser Epitaxieschicht, die auf ein hoch dotiertes Substrat, das die Rekombination von Ladungsträgern gewährleistet, die außerhalb der Absorptionszone auftreten, aufgebracht ist. Das heißt, die im dotierten Substrat erzeugten Ladungsträger dienen nicht nur der Erzeugung des Nutzsignals des Halbleiterbauelements 103, sondern nur die in der dünnen Epitaxieschicht.
- Als weitere Möglichkeit kann eine dünne Halbleiterscheibe, zum Beispiel aus Silizium, in welcher ein p-n-Übergang zur Detektion von einfallender elektromagnetischer Strahlung angeordnet ist, auf eine Schicht aus einem dielektrischen Material angeordnet sein. Über das dielektrische Material kann die dünne Halbleiterscheibe beispielsweise auf einen Silizium- oder Saphirträger gebondet sein. Auch in diesem Fall ist das für die Erzeugung des Fotostroms genutzte Volumen mittels einer dünnen Absorptionszone 2 begrenzt.

Die Dicke der Absorptionszone 2 wird dabei beispielsweise von der Strahlungseintrittsfläche 1a des Halbleiterkörpers 1 in Richtung zu der Strahlungseintrittsfläche 1a abgewandten Unterseite des Halbleiterkörpers 1 senkrecht zur Strahlungseintrittsfläche 1a gemessen.

Direkt auf der Strahlungseintrittsfläche 1a des Halbleiterkörpers 1 ist die Filterschicht 3 angeordnet. Die Filterschicht 3 überdeckt die Strahlungseintrittsfläche 1a vollständig, sodass sämtliche elektromagnetische Strahlung 10, die in den Halbleiterkörper 1 eindringt, die Filterschicht durchlaufen muss. Vorliegend handelt es sich bei der Filterschicht um eine besonders einfache optische Filterschicht, welche maximal zehn Schichten 31, 32, vorliegend zum Beispiel vier Schichten aufweist. Die Schichten 31 bestehen beispielsweise aus Siliziumdioxid, die Schichten 32 bestehen beispielsweise aus Si3N4. Die Filterschicht 3 filtert dabei elektromagnetische Strahlung in einem Wellenlängenbereich für Infrarotstrahlung aus der einfallenden elektromagnetischen Strahlung 10. Es handelt sich bei dem Filter um einen Interferenzkantenfilter.

Direkt auf die Filterschicht 3 und direkt auf Teile des Halbleiterkörpers 1 ist ein Vergusskörper 4 aufgebracht. Der Vergusskörper 4 besteht beispielsweise aus einem Epoxydharz, aus Silikon oder einem Epoxydharz-Silikon-Hybridmaterial. In den Vergusskörper 4 ist ein strahlungsabsorbierendes Material 5, zum Beispiel als Schicht, eingebracht. Elektromagnetische Strahlung 10, die auf das Halbleiterbauelement 100 trifft, durchläuft zunächst den Vergusskörper 4 mit dem strahlungsabsorbierenden Material 5, bevor die Strahlung auf die Filterschicht 3 trifft. Das strahlungsabsorbierende Material 5 absorbiert einen Teil der Infrarotstrahlung, welche in der elektromagnetischen Strahlung 10 vorhanden ist. Die Kombination einer Filterschicht 3 und eines strahlungsabsorbierenden Materials 5 im Vergusskörper 4 erlaubt es dabei zum einen weniger vom teuren strahlungsabsorbierenden Material 5 zu verwenden und zum anderen die Filterschicht 3 besonders einfach, zum Beispiel mit weniger als zehn Einzelschichten, auszuführen.

Insbesondere ermöglicht die Kombination von strahlungsabsorbierendem Material 5 und Filterschicht 3 damit ein besonders kostengünstig herstellbares optoelektronischen Halbleiterbauelement 100.

Das optoelektronische Halbleiterbauelement 100 ist auf einem Anschlussträger 6, bei dem es sich zum Beispiel um eine Metallkernplatine handelt, aufgebracht. Das Halbleiterbauelement 100 ist dabei beispielsweise auf den Anschlussträger 6 an seiner Oberseite 6a aufgeklebt und über Drahtkontakte (in dieser Schnittdarstellung nicht dargestellt) elektrisch an den Anschlussträger 6 angeschlossen.

Der Vergusskörper 4 bedeckt den Anschlussträger 6 lediglich an seiner Oberseite 6a und weist eine maximale Dicke D von 600 µm auf. Auf diese Weise kann zum einen besonders wenig Vergussmaterial des Vergusskörpers Verwendung finden, was eine kostengünstige Herstellung des optoelektronischen Bauteils ermöglicht. Zum anderen wird durch einen so dünnen Vergusskörper 4 die zu detektierende elektromagnetische Strahlung 10, das heißt insbesondere die Anteile der elektromagnetischen Strahlung 10, die im Bereich der menschlichen Augenempfindlichkeitskurve liegen, kaum abgeschwächt. Es kann also ein starkes Nutzsignal mit dem optoelektronischen Bauteil erzeugt werden.

In den Figuren 2A bis 2C ist jeweils die relative spektrale Empfindlichkeit des menschlichen Auges im Vergleich zur relativen spektralen Empfindlichkeit verschiedener strahlungsempfangender Halbleiterbauelemente 100 aufgetragen.

Die Figur 2A zeigt zum einen die menschliche Augenempfindlichkeitskurve 21 sowie die Empfindlichkeitskurve einer Siliziumfotodiode, bei der keine der hier beschriebenen Maßnahmen angewendet wurde. Das heißt, die Siliziumfotodiode umfasst weder eine besonders dünne Absorptionszone, noch eine Filterschicht, noch einen Vergusskörper mit strahlungsabsorbierendem Material. Das Maximum der Empfindlichkeit liegt dann, wie aus der Kurve 22 ersichtlich, zwischen 800 und 900 nm.

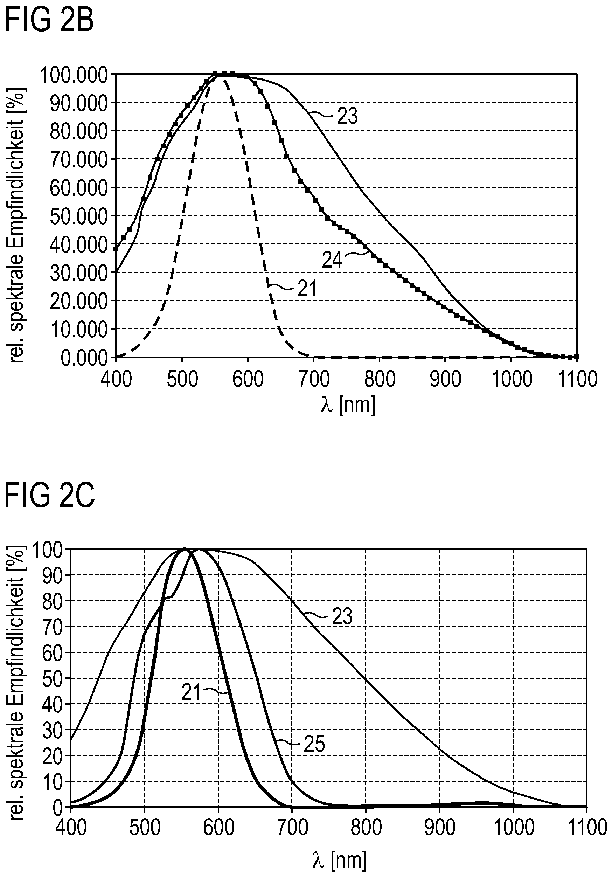

In der Figur 2B ist die menschliche Augenempfindlichkeitskurve 21 zwei weiteren Kurven 23, 24 gegenüber gestellt. Die Kurve 23 zeigt die Empfindlichkeitskurve einer Siliziumfotodiode, bei der die Absorptionszone 2 eine Dicke von weniger als 10 µm aufweist. Wie aus der Figur 2B ersichtlich, ist das sehr breite Maximum dieser Empfindlichkeitskurve 23 bereits in den Wellenlängenbereich zwischen 500 und 600 nm verschoben.

Die Kurve 24 zeigt die Empfindlichkeitskurve einer Siliziumfotodiode mit einer dünnen Absorptionszone 2, bei der eine Filterschicht 3 auf der Strahlungseintrittsfläche 1a angeordnet ist. Bei der Filterschicht 3 handelt es sich dabei um eine einfache Filterschicht, die höchstens zehn Einzelschichten umfasst.

Schließlich ist in Figur 2C die relative spektrale Empfindlichkeitskurve 25 für ein hier beschriebenes strahlungsempfangendes Halbleiterbauelement gezeigt, wie es in Verbindung mit Figur 1 beschrieben ist.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Halbleiterbauelement zur Detektion elektromagnetischer Strahlung mit
- einem Halbleiterkörper (1), der mit Silizium gebildet ist und eine Strahlungseintrittsfläche (1a) sowie eine Absorptionszone (2) aufweist, in der durch die Strahlungseintrittsfläche (1a) in den Halbeiterkörper (1) tretende elektromagnetische Strahlung (10) absorbiert wird, wobei die Absorptionszone (2) eine Dicke (d) von höchstens 10 µm aufweist,
- einer Filterschicht (3), die mit einem dielektrischen Material gebildet ist, wobei die Filterschicht (3) die Strahlungseintrittsfläche (1a) des Halbleiterkörpers (1) bedeckt und zur Filterung von Infrarotstrahlung vorgesehen ist, so dass Infrarotstrahlung am Eindringen in den Halbleiterkörper (1) gehindert wird oder in ihrer Intensität zumindest abgeschwächt wird, und die Filterschicht (3) in direktem Kontakt mit der Strahlungseintrittsfläche (1a) des Halbleiterkörpers (1) ist, wobei es sich bei der Filterschicht (3) um einen Interferenzkantenfilter handelt, und
- einem Vergusskörper (4), der den Halbleiterkörper (1) zumindest an seiner Strahlungseintrittsfläche (1a) überdeckt, wobei der Vergusskörper (4) ein strahlungsabsorbierendes Material (5) enthält, das zur Absorption von Infrarotstrahlung vorgesehen ist, wobei elektromagnetische Strahlung (10), die auf das Halbleiterbauelement (100) trifft, zunächst den Vergusskörper (4) mit dem strahlungsabsorbierenden Material (5) durchläuft, bevor die Strahlung auf die Filterschicht (3) trifft.

2. Halbleiterbauelement zur Detektion elektromagnetischer Strahlung nach dem vorherigen Anspruch,
bei dem lediglich in der Absorptionszone absorbierte elektromagnetische Strahlung zur Erzeugung eines Signals des strahlungsempfangenden Halbleiterbauelements beiträgt.

3. Halbleiterbauelement zur Detektion elektromagnetischer Strahlung nach einem der vorherigen Ansprüche,
bei dem die Filterschicht (3) zumindest eine Schicht (31, 32) umfasst, die aus einem der folgenden Materialien gebildet ist: Siliziumoxid, Siliziumnitrid.

4. Halbleiterbauelement zur Detektion elektromagnetischer Strahlung nach einem der vorherigen Ansprüche,
bei dem der Halbleiterkörper (1) aus Silizium und Dotierstoffen besteht, wobei
- die Absorptionszone (2) eine Dicke zwischen wenigstens 2 µm und höchstens 5 µm aufweist,
- die Filterschicht (3) elektromagnetische Strahlung im Wellenlängenbereich aus dem nahen Infrarot von Wellenlängen zwischen 800 nm und 1100 nm am Eindringen in den Halbleiterkörper (1) hindert,
- die Absorptionszone (2) unmittelbar an die Strahlungseintrittsfläche (1a) des Halbleiterkörpers (1) angrenzt, und
- das strahlungsabsorbierende Material sich im nur innerhalb einer Schicht innerhalb des Vergusskörpers (4) befindet und diese Schicht an ihren Hauptflächen vollständig vom Vergusskörper (4) ohne absorbierendes Material bedeckt ist.

5. Halbleiterbauelement zur Detektion elektromagnetischer Strahlung nach einem der vorherigen Ansprüche,
bei dem der Vergusskörper (4) zumindest eines der folgenden Materialien enthält: Silikon, Epoxidharz.

6. Halbleiterbauelement zur Detektion elektromagnetischer Strahlung nach einem der vorherigen Ansprüche,
bei dem das strahlungsabsorbierende Material (5) in Form von Partikeln ist und innerhalb einer Schicht innerhalb des Vergusskörpers angeordnet ist.

7. Halbleiterbauelement zur Detektion elektromagnetischer Strahlung nach einem der vorherigen Ansprüche,
bei dem die Filterschicht (3) höchstens zehn Schichten (31, 32) umfasst.

8. Halbleiterbauelement zur Detektion elektromagnetischer Strahlung nach einem der vorherigen Ansprüche,
bei dem die Filterschicht mehrere Schichten aus Siliziumoxid und Siliziumnitrid umfasst, die sich hinsichtlich ihres Brechungsindex voneinander unterscheiden und einen Interferenzkantenfilter ausbilden.

9. Halbleiterbauelement zur Detektion elektromagnetischer Strahlung nach einem der vorherigen Ansprüche,
bei dem in einem zweistufigen Absorptions- und Filterprozess der Anteil der elektromagnetischen Strahlung mit einer Wellenlänge oberhalb von 800 nm in ihrer Intensität zumindest abgeschwächt wird.

10. Halbleiterbauelement zur Detektion elektromagnetischer Strahlung nach einem der vorherigen Ansprüche,
bei dem die Filterschicht (3) zwischen dem Halbleiterkörper (1) und dem Vergusskörper (4) angeordnet ist.

11. Halbleiterbauelement zur Detektion elektromagnetischer Strahlung nach dem vorherigen Anspruch,
bei dem sich der Vergusskörper (4) zumindest stellenweise in direktem Kontakt mit der Filterschicht (3) befindet.

12. Halbleiterbauelement zur Detektion elektromagnetischer Strahlung nach dem vorherigen Anspruch,
bei dem der Vergusskörper (4) eine maximale Dicke (D) von 600 µm aufweist.

13. Optoelektronisches Bauteil mit
- einem Anschlussträger (6), der eine Oberseite (6a) aufweist,
- einem Halbleiterbauelement (100) zur Detektion elektromagnetischer Strahlung nach einem der vorherigen Ansprüche, das an der Oberseite (6a) des Anschlussträgers (6) auf diesem befestigt ist, wobei
- der Vergusskörper (4) des Halbleiterbauelements (100) in direktem Kontakt mit dem Anschlussträger (6) steht und eine maximale Dicke (D) von 600 µm aufweist.

14. Optoelektronisches Bauteil nach dem vorherigen Anspruch, bei dem sich der Vergusskörper (4) ausschließlich an der Oberseite (6a) des Anschlussträgers (6) mit dem Anschlussträger (6) in Kontakt befindet.

## Claims

1. A semiconductor component for detecting electromagnetic radiation having
- a semiconductor body (1) which is formed with silicon and has a radiation entrance surface (1a) as well as an absorption zone (2), in which electromagnetic radiation (10) passing through the radiation entrance surface (1a) into the semiconductor body (1) is absorbed, wherein the absorption zone (2) has a thickness (d) of at most 10 µm,
- a filter layer (3) which is formed with a dielectric material, wherein the filter layer (3) covers the radiation entrance surface (1a) of the semiconductor body (1) and is provided for filtering infrared radiation so that infrared radiation is prevented from penetrating into the semiconductor body (1) or is at least attenuated in its intensity, and the filter layer (3) is in direct contact with the radiation entrance surface (1a) of the semiconductor body (1), wherein the filter layer (3) is an interference edge filter, and
- amould body (4) covering the semiconductor body (1) at least on its radiation entrance surface (1a), wherein the mould body (4) contains a radiation-absorbing material (5) which is provided for absorbing infrared radiation, wherein electromagnetic radiation (10) which impinges on the semiconductor component (100), initially passes through the mould body (4) with the radiation-absorbing material (5) before the radiation impinges on the filter layer (3).

2. A semiconductor component for detecting electromagnetic radiation according to the preceding claim,
wherein electromagnetic radiation which is absorbed only in the absorption zone contributes to the generation of a signal of the radiation-receiving semiconductor component.

3. A semiconductor component for detecting electromagnetic radiation according to any of the preceding claims,
wherein the filter layer (3) comprises at least a layer (31, 32) which is formed from one of the following materials: silicon oxide, silicon nitride.

4. A semiconductor component for detecting electromagnetic radiation according to any of the preceding claims,
wherein the semiconductor body (1) consists of silicon and dopants, wherein
- the absorption zone (2) has a thickness between at least 2 µm and at most 5 µm,
- the filter layer (3) prevents electromagnetic radiation in the wavelength range from the near-infrared of wavelengths between 800 nm and 1100 nm from penetrating into the semiconductor body (1),
- the absorption zone (2) directly adjoins the radiation entrance surface (1a) of the semiconductor body (1), and
- the radiation-absorbing material is within only one layer within the mould body (4), and this layer, on its main surfaces, is completely covered by the mould body (4) without the absorbing material.

5. A semiconductor component for detecting electromagnetic radiation according to any of the preceding claims,
wherein the mould body (4) contains at least one of the following materials: silicone, epoxy resin.

6. A semiconductor component for detecting electromagnetic radiation according to any of the preceding claims,
wherein the radiation-absorbing material (5) is in the form of particles and is arranged within a layer within the mould body.

7. A semiconductor component for detecting electromagnetic radiation according to any of the preceding claims,
wherein the filter layer (3) comprises at most ten layers (31, 32).

8. A semiconductor component for detecting electromagnetic radiation according to any of the preceding claims,
wherein the filter layer comprises several layers of silicon oxide and silicon nitride which differ from one another with regard to their refractive index and which form an interference edge filter.

9. A semiconductor component for detecting electromagnetic radiation according to any of the preceding claims,
wherein, in a two-stage absorption and filtering process, the portion of the electromagnetic radiation having a wavelength of more than 800 nm is at least attenuated in its intensity.

10. A semiconductor component for detecting electromagnetic radiation according to any of the preceding claims,
wherein the filter layer (3) is arranged between the semiconductor body (1) and the mould body (4).

11. A semiconductor component for detecting electromagnetic radiation according to the preceding claim,
wherein the mould body (4) is, at least in places, in direct contact with the filter layer (3).

12. A semiconductor component for detecting electromagnetic radiation according to the preceding claim,
wherein the mould body (4) has a maximum thickness (D) of 600 µm.

13. An optoelectronic device having
- a connection carrier (6) having an upper side (6a),
- a semiconductor component (100) for detecting electromagnetic radiation according to any of the preceding claims, which is attached to the upper side (6a) of the connection carrier (6) thereon, wherein
- the mould body (4) of the semiconductor component (100) is in direct contact with the connection carrier (6) and has a maximum thickness (D) of 600 µm.

14. An optoelectronic device according to the preceding claim, wherein the mould body (4) is in contact with the connection carrier (6), exclusively on the upper side (6a) of the connection carrier (6).

## Revendications

1. Composant semi-conducteur pour la détection de rayonnement électromagnétique comprenant
- un corps semi-conducteur (1) formé avec le silicium et comportant une surface d'entrée de rayonnement (1a) et une zone d'absorption (2), dans laquelle un rayonnement électromagnétique (10) passant à travers la surface d'entrée de rayonnement (1a) dans le corps semi-conducteur (1) est absorbé, la zone d'absorption (2) présentant une épaisseur (d) d'au plus 10 µm,
- une couche filtrante (3), qui est formée avec un matériau diélectrique, la couche filtrante (3) recouvrant la surface d'entrée de rayonnement (1a) du corps semi-conducteur (1) et étant prévue pour filtrer le rayonnement infrarouge, si bien que le rayonnement infrarouge est empêché de pénétrer dans le corps semi-conducteur (1) ou au moins affaibli dans son intensité, et la couche filtrante (3) étant en contact direct avec la surface d'entrée de rayonnement (1a) du corps semi-conducteur (1), la couche filtrante (3) étant prévue dans la forme d'un filtre de bord d'interférence, et
- un corps d'enrobage (4) qui recouvre le corps semi-conducteur (1) au moins à sa surface d'entrée de rayonnement (1a), le corps d'enrobage (4) contenant un matériau absorbant les rayonnements (5), qui est prévu pour l'absorption de rayonnement infrarouge, le rayonnement infrarouge (10), qui touche le composant semi-conducteur (100), passe d'abord par le corps d'enrobage (4) avec le matériau absorbant les rayonnements (5), avant que le rayonnement ne touche la couche filtrante (3).

2. Composant semi-conducteur pour la détection de rayonnement électromagnétique selon la revendication précédente,
dans lequel le rayonnement infrarouge qui n'est absorbé que dans la zone d'absorption fait partie de la génération d'un signal du composant semi-conducteur récepteur de rayonnement.

3. Composant semi-conducteur pour la détection de rayonnement électromagnétique selon l'une des revendications précédentes,
dans lequel la couche filtrante (3) comprend au moins une couche (31, 32) qui est formée à partir de l'un des matériaux suivants : l'oxyde de silicium, le nitrure de silicium.

4. Composant semi-conducteur pour la détection de rayonnement électromagnétique selon l'une des revendications précédentes,
dans lequel le corps semi-conducteur (1) est constitué de silicium et de dopants, dans lequel
- la zone d'absorption (2) présente une épaisseur comprise entre au moins 2 µm et au plus 5 µm,
- la couche filtrante (3) empêche le rayonnement électromagnétique dans les plages de longueur d'onde de l'infrarouge proche entre 800 nm et 1100 nm de pénétrer dans le corps semi-conducteur (1),
- la zone d'absorption (2) est immédiatement adjacente à la surface d'entrée de rayonnement (1a) du corps semi-conducteur (1), et
- le matériau absorbant les rayonnements est situé au sein d'une seule couche à l'intérieur du corps d'enrobage (4), et cette couche est à ses surfaces principales complètement recouverte par le corps d'enrobage (4) sans du matériau absorbant.

5. Composant semi-conducteur pour la détection de rayonnement électromagnétique selon l'une des revendications précédentes,
dans lequel le corps d'enrobage (4) contient au moins l'un des matériaux suivants: le silicone, la résine époxy.

6. Composant semi-conducteur pour la détection de rayonnement électromagnétique selon l'une des revendications précédentes,
dans lequel le matériau absorbant les rayonnements (5) est prévu dans la forme de particules et est arrangé au sein d'une couche à l'intérieur du corps d'enrobage.

7. Composant semi-conducteur pour la détection de rayonnement électromagnétique selon l'une des revendications précédentes,
dans lequel la couche filtrante (3) comprend au plus dix couches (31, 32).

8. Composant semi-conducteur pour la détection de rayonnement électromagnétique selon l'une des revendications précédentes,
dans lequel la couche filtrante comprend plusieurs couches en oxyde de silicium et nitrure de silicium, qui se distinguent l'une de l'autre en fonction de leur indice de réfraction et forment un filtre de bord d'interférence.

9. Composant semi-conducteur pour la détection de rayonnement électromagnétique selon l'une des revendications précédentes,
dans lequel, dans un procédé d'absorption et de filtrage en deux étapes, la portion du rayonnement électromagnétique ayant une longueur d'onde supérieure à 800 nm est au moins affaiblie dans son intensité.

10. Composant semi-conducteur pour la détection de rayonnement électromagnétique selon l'une des revendications précédentes,
dans lequel la couche filtrante (3) est disposée entre le corps semi-conducteur (1) et le corps d'enrobage (4).

11. Composant semi-conducteur pour la détection de rayonnement électromagnétique selon la revendication précédente,
dans lequel le corps d'enrobage (4) est au moins par endroits en contact direct avec la couche filtrante (3).

12. Composant semi-conducteur pour la détection de rayonnement électromagnétique selon la revendication précédente,
dans lequel le corps d'enrobage (4) présente une épaisseur maximale (D) de 600 µm.

13. Composant optoélectronique comprenant
- un support de connexion (6) ayant un côté supérieur (6a),
- un composant semi-conducteur (100) pour la détection de rayonnement électromagnétique selon l'une des revendications précédentes, qui est fixé au sommet (6a) du support de connexion (6), dans lequel
- le corps d'enrobage (4) du composant semi-conducteur (100) est en contact direct avec le support de connexion (6) et présente une épaisseur maximale (D) de 600 µm.

14. Composant optoélectronique selon la revendication précédente, dans lequel le corps d'enrobage (4) est exclusivement en contact avec le support de connexion (6) sur le côté supérieur (6a) du support de connexion (6).
